# EUROPEAN PATENT APPLICATION

(11) **EP 2 762 840 A1**
(43) Date of publication of application: **06.08.2014**
(21) Application number: 13405015.2
(22) Date of filing: 31.01.2013
(51) Int. Cl.: G01D 11/24, H01L 21/768, H01L 23/48

(54) **Portable electronic device with sensors chip and through-silicon vias**

(71) Applicant: Sensirion AG, 8712 Stäfa (CH)
(72) Inventor: Mayer, Felix, 8712 Stäfa (CH); Lechner, Moritz, 8713 Uerikon (CH); Graf, Markus, 8005 Zürich (CH)
(74) Representative: Fischer, Britta Ruth

(57) **Abstract**

The invention relates to a portable electronic device (2) with a housing (3) and several separate sensors (1; 1.1, 1.2, 1.3) placed inside the housing (3), the several sensors (1; 1.1, 1.2, 1.3) being designed to measure different physical quantities, wherein each sensor (1; 1.1, 1.2, 1.3) is designed as sensor chip with a substrate layer (4) and a sensing layer (5) placed on the substrate layer (4), wherein the sensing layer (5) comprises a signal processing circuit (6), and wherein the substrate layer (4) is provided with at least one via (7) for electrically connecting the signal processing circuit (6) of the sensing layer (5) to a contact pad (8) provided on the substrate layer side that is opposite to the sensing layer (5), the at least one via (7) extending from the substrate layer side that is adjacent to the sensing layer (5) to the opposite substrate layer side.

## Description

### Technical Field

The invention relates to a portable electronic device such as for example a mobile phone, a smart phone, a tablet computer, a notebook or similar.

### Background Art

Mobile phones or other portable electronic devices are often provided with a number of sensors for measuring physical quantities such as for example a light sensor and an acceleration sensor. For compact design the several sensors are typically realized as one multi-sensor chip. However, this has several disadvantages and may be less efficient as it appears.

For example, manufacturing processes of the different sensors can often not easily be combined. Different sensor types usually require different manufacturing processes. Furthermore, certain sensors may require to be positioned at specific locations within the portable electronic device. For example, chemical sensors and humidity sensors require access to the ambient air and have to be positioned close to openings provided in the housing of the respective electronic device. For other sensors such as pressure sensors and acceleration sensors location is usually less critical.

Moreover, the close proximity and integration of several sensors that are realized as one multi-sensor chip may lead to the measuring of one sensor disturbing, in particular biasing, the measurement outputs of one or more of the other sensors. For example, reaction products generated by a chemical sensor during measuring may disturb the measurement outputs of a humidity sensor.

### Disclosure of the Invention

It is an object of the invention to provide a portable electronic device by which the above-mentioned drawbacks can be avoided.

In order to implement these and still further objects of the invention, which will become more readily apparent as the description proceeds, a portable electric device with a housing and several separate sensors arranged inside the housing is provided. The several sensors are designed to measure different physical quantities. I.e. for each physical quantity to be measured a sensor is provided. Of course, there may be several sensors provided that measure the same physical quantity.

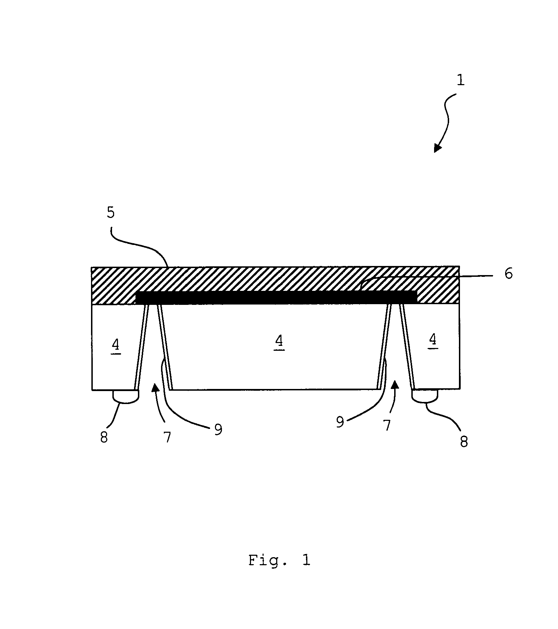

Each sensor of the portable electric device of the invention is designed as sensor chip with a substrate layer and a sensing layer that is placed on top of the substrate layer. The sensing layer comprises a signal processing circuit, which is an electrical circuit, that processes the input signal of the respective sensor, the input signal corresponding to the physical quantity to be measured. The material of the substrate layer is for example silicon. The sensor may comprise further components such as for example spacers placed opposite to the substrate layer on top of the sensing layer. Expressions such as "top", "bottom", "vertically", "horizontally" and similar are to be understood with reference to Figure 1.

The substrate layer of each sensor is provided with at least one via for electrically connecting the signal processing circuit of the sensing layer to a contact pad provided on the substrate layer side that is opposite to the sensing layer. For this, the at least one via extends from the substrate layer side that is adjacent to the sensing layer to the opposite side of the substrate layer. The at least one via is preferably given by a so-called through-silicon via (TSV; http://en.wikipedia.org/wiki/Through-silicon_via). The contact pad may then be electrically connected to an external electrical circuit inside the portable electronic device.

Physical quantities to be measured by the various sensors are, for example, humidity, pressure, presence, nature and/or amount of a chemical substance, temperature, acceleration, orientation, characteristics of a magnetic field, light/light intensity, and proximity of a nearby object and similar. Hence, the portable electronic device according to the invention may comprise a humidity sensor, a pressure sensor, a chemical sensor (which may be a gas sensor), an acoustic sensor in form of a microphone, a temperature sensor, an acceleration sensor, a gyroscopic sensor, a magnetic field sensor, a light sensor, a proximity sensor, with this list being non-exhaustive. Several sensors of the same type may be provided.

Providing each sensor with at least one via for electrical connection with an external electrical circuit by way of a contact pad leads to small sensors that can be placed numerously and independently of each other inside the housing of the portable electronic device. Hence, specific requirements of individual sensors regarding their placement, e.g. close to an opening in the housing (such as for humidity sensors and chemical sensors), can be taken into account for such sensors without the location of the other sensors being compromised. Moreover, as each sensor is separate from the other sensors the most-efficient manufacturing process can be employed for each sensor depending on the particular sensor type. I.e. no compromise between various manufacturing processes needs to be made, which might lead to less efficient sensors. Also, sensor interferences can advantageously avoided by placing the sensors sufficiently far apart from each other.

### Brief Description of the Drawings

Further advantageous features and applications of the invention can be found in the dependent claims, as well as in the following description of the drawings illustrating the invention. In the drawings like reference signs designate the same or similar parts/components throughout the several figures of which:
Fig. 1 shows a schematic drawing of a sensor of a portable electronic device according to the invention, and
Fig. 2 shows a schematic drawing of a portable electronic device according to the invention.

### Mode(s) for Carrying out the Invention

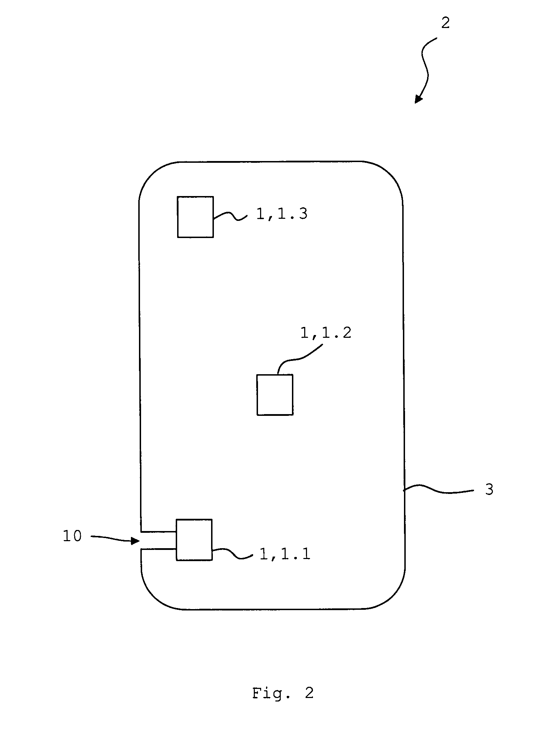

Figure 1 shows a sensor 1 to be arranged inside a housing 3 of a portable electronic device 2 according to the invention (see Figure 2).

The sensor 1 is designed as sensor chip comprising a substrate layer 4 and a sensing layer 5 with the sensing layer 5 being placed on top of the substrate layer 4. The sensing layer 5 serves for measuring of a physical quantity and comprises a signal processing circuit 6 for processing an input signal to the sensor 1 and its sensing layer 5, respectively. The sensing layer 5 preferably comprises a specific sensing element (not shown) for performing the measuring function, the sensing element being exposable to the fluid to be analysed. For protection of the sensing element the sensing layer 5 may comprise a handling layer (not shown) that apart from protecting the sensing element may be used for handling (e.g. gripping or similar) the entire sensor 1. It is noted that the drawing of Figure 1 is of purely schematic nature, i.e. the specific design of the sensing layer 5 and the signal processing circuit 6 may differ from the depicted ones.

The substrate layer 4 exemplarily comprises two vias 7, in particular so-called through-silicon vias, for electrically connecting the signal processing circuit 6 with contact pads 8 arranged on the bottom side of the substrate layer, i.e. that side that is opposite to the sensing layer 5. Fewer or more vias 7 may be provided. The contact pads 8 can then be electrically connected to an electrical circuit (not shown) of the portable electronic device 2 that is external to the sensor 1 for further signal processing.

Each via 7 extends vertically through the substrate layer 4 from the side of the substrate layer 4 that is adjacent to the sensing layer 5 to the opposite side of the substrate layer 4. The vias 7 are preferably isolated from the surrounding substrate 4, preferably by a layer of SiO₂ (not shown), and are filled with conducting material 9, in particular coated with conducting material on their respective inner wall, to form the electrical connection between the signal processing circuit 6 and the contact pads 8.

Figure 2 shows a portable electronic device 2, in particular a smart phone, according of the invention. The portable electronic device 2 comprises a housing 3. Inside the housing 3 several sensors 1 are provided as depicted in Figure 1. As each sensor 1 comprises its own means for electrical connection with an external circuit in form of the via(s) 7 and the contact pad(s) 8, the sensors 1 may be arranged independently from each other inside the housing 3. By this the advantage can be achieved, that sensors for measuring different physical quantities may be placed according to their individual, specific requirements for optimal/efficient use, and such that they do not impair each other's functioning/measurement accuracy.

In Figure 2 the portable electronic device 2 is exemplarily equipped with a humidity or a chemical sensor 1.1, an acceleration sensor 1.2 and a pressure sensor 1.3. The humidity or chemical sensor 1.1 is placed next to an opening 10 provided in the housing 3 such that ambient air can reach the humidity or chemical sensor 1.1 by way of the opening 10. As the acceleration sensor 1.2 and the pressure sensor 1.3 are provided with their own vias 7 and contact pads 8 they can be positioned independently from the humidity or chemical sensor 1.1 (and from each other) inside the housing 3 as exemplarily shown in Figure 2, in particular at distances that avoid interferences. The acceleration sensor 1.2 is preferably entirely hermetically sealed. The pressure sensor 1.3 is preferentially arranged such that it is protected from visible light. The pressure sensor 1.3 may also be hermetically sealed.

Providing the sensors 1 with vias 7 for electrical connection to an external processing circuit by way of contact pads 8 leads to sensors 1 with smaller horizontal dimensions than if edge wiring was used instead. This leads to a higher number of sensors 1 that can be arranged inside a portable electronic device 2, in particular a smart phone.

It is to be understood that while certain embodiments of the present invention have been illustrated and described herein, it is not to be limited to the specific embodiments described and shown.

## Claims

1. Portable electronic device with a housing (3) and several separate sensors (1; 1.1, 1.2, 1.3) arranged inside the housing (3), the several sensors (1; 1.1, 1.2, 1.3) being designed to measure different physical quantities, **characterized in that**
- each sensor (1; 1.1, 1.2, 1.3) is designed as sensor chip with a substrate layer (4) and a sensing layer (5) placed on the substrate layer (4),
- wherein the sensing layer (5) comprises a signal processing circuit (6),
- wherein the substrate layer (4) is provided with at least one via (7) for electrically connecting the signal processing circuit (6) of the sensing layer (5) to a contact pad (8) provided on the substrate layer side that is opposite to the sensing layer (5),
- the at least one via (7) extending from the substrate layer side that is adjacent to the sensing layer (5) to the opposite substrate layer side.

2. Portable electronic device according to claim 1, wherein the at least one via (7) is given by a through-silicon via.

3. Portable electronic device according to claim 1 or 2, wherein the several sensors (1; 1.1, 1.2, 1.3) comprise a humidity sensor, a pressure sensor (1.3), a chemical sensor (1.1), an acceleration sensor (1.2), a microphone and/or a temperature sensor.
